# EUROPEAN PATENT SPECIFICATION

(11) **EP 3 464 816 B1**
(45) Date of publication and mention of the grant of the patent: **16.03.2022**
(21) Application number: 16903375.0
(22) Date of filing: 31.05.2016
(51) Int. Cl.: E21B 47/085, G01B 7/12, G01R 33/07, E21B 47/09

(54) **APPARATUS FOR MEASURING A PIPE WITHIN AN OIL WELL STRUCTURE**
VORRICHTUNG ZUM MESSEN EINES ROHRES IN EINER ÖLBOHRLOCHSTRUKTUR
APPAREIL DE MESURE D'UN TUYAU DANS UNE STRUCTURE DE PUITS DE PÉTROLE

(43) Date of publication of application: 10.04.2019
(73) Proprietor: Intelligent Wellhead Systems Inc., Sturgeon County, Alberta T8T 0B6 (CA)
(72) Inventor: CARLSON, Aaron Mitchell, Lake Country, British Columbia V4V 1A2 (CA); MARTIN, Bradley Robert, Red Deer, Alberta T4E 1P4 (CA)
(74) Representative: Letzelter, Felix Phillip
(86) International application number: PCT/CA2016/050615
(87) International publication number: WO 2017/205955

(56) References cited:
- EP-A1- 2 893 137
- WO-A1-2015/145130
- CA-A- 1 029 810
- CA-A1- 2 448 172
- CA-A1- 2 882 598
- CA-A1- 2 915 632
- CN-A- 1 804 371
- CN-Y- 2 818 777
- RU-C1- 2 401 383
- US-A- 3 284 701
- US-B2- 6 720 764

## Description

### BACKGROUND OF THE INVENTION

### 1. Field of Invention

The present invention relates to well boring in general and in particular to an apparatus for measuring a pipe within a well structure.

### 2. Description of Related Art

In hydrocarbon production, a well may be formed by an outer casing located within a wellbore and may optionally be surrounded by cement. The well may then include a tool or production string therein for working or producing from the well. Due to the potentially high pressures within the well from hydrocarbons extracted from the hydrocarbon producing formation, numerous types of shut-off valves, spools and other fittings to isolate and control access to the well, such as, by way of non-limiting example a blow out preventer (BOP) stock, as it is commonly known or a snubbing unit.

The well structure may include shut-off valves for closing off or otherwise completely or partially sealing the top of the well as desired by a user. In particular, one common design for such valves are pipe rams which utilize a pair of opposed rams which are movable along a plane perpendicular to the well bore. The rams may be moved along the plate by pistons or the like and are operable to be moved out of the central passage of the well or to be pressed together to seal the well. Rams may be of a blind or shear type to completely seal the well or of a pipe ram type in which the two rams each include a half-circle hole sized to pass a pipe therethrough when the two rams are pressed together. Such pipe rams are commonly utilized in snubbing units to seal around the drill or production string and isolate the well below the pipe ram from the environment while permitting the drill or production string to remain within the well or to be extracted or inserted into the well.

One difficulty that exists with common hydrocarbon wells is the difficulty of determining the location of the connections on the tool or production string. Such strings are commonly formed of a plurality of endwise connected pipes which are connected to each other by threaded connectors. Conventionally such threaded connectors are located at each end and provide enlarged portions of the pipe which are strengthened so as to provide a larger stronger section of the pipe to be grasped by tools and the like. Such tool joints present a larger cross-section than the remainder of the pipe. Disadvantageously, such enlarged diameters of tool joints may interfere with the proper operation of pipe rams should the pipe ram be attempted to be closed at the location of such a tool joint or when extracting or inserting the pipe when at least one of the rams is set to hold back the pressure. Such an event is commonly referred to as stripping which may create a risk of the tool joint being pulled or pushed into the closed pipe ram thereby damaging the pipe and/or pipe ram.

US 6,720,764 B2, WO 2015/145130 A1 and EP 2 893 137 A1 can be cited as prior art and disclose apparatuses for measuring a pipe within a well structure by magnetic sensing means.

### SUMMARY OF THE INVENTION

According to a first embodiment of the present invention there is disclosed an apparatus for measuring a pipe within a well structure according to claim 1.

The tubular body may include at least one housing each extending around one of the at least one sensor stack or one of the at least one magnetic stack.

Each housing may comprise a sleeve. The sleeves may be formed of a ferrous metal alloy. Each of said at least one sensor stack and said at least one magnetic stacks may extend radially from said tubular body.

The sensor stack may comprise a sensor output a signal representing the diameter of the metallic object located within the central bore. The sensor may comprise a hall effects sensor. The sensor may be located at proximate to an outer surface of the tubular body. The sensor stack may include a magnet located at an end of the blind bore opposite to the sensor.

The magnet stack comprises at least one magnet. The magnet may comprise a plurality of magnets. The magnet may comprises rare earth magnets. The magnet may comprises electromagnets.

The sensor stack and magnetic stack may be are arranged around the tubular body. The sensor stack and magnetic stack may be arranged at regular intervals around the tubular body. The sensor stack and magnetic stack may be arranged along a common plane perpendicular to an axis of the tubular body. The sensor stack and magnetic stack may be arranged along a plurality of planes.

According to a further embodiment of the present invention there is disclosed a system for measuring a pipe within a well structure according to claim 17.

Other aspects and features of the present invention will become apparent to those ordinarily skilled in the art upon review of the following description of specific embodiments of the invention in conjunction with the accompanying figures.

### BRIEF DESCRIPTION OF THE DRAWINGS

In drawings which illustrate embodiments of the invention wherein similar characters of reference denote corresponding parts in each view,
- Figure **1**: is a cross-sectional view of the top end of a wellbore having an outer casing and a production string located therein with an apparatus for sensing the location of a pipe joint.
- Figure **2**: is a perspective view of the apparatus for sensing the location of a pipe joint according to a first embodiment of the present invention.
- Figure **3**: is a cross-sectional view of the apparatus of Figure **3** as taken along the line **3-3.**
- Figure **4**: is a cross-sectional view of the apparatus of Figure **3** as taken along the line **4-4.**
- Figure **5**: is an illustration of a display output showing voltage produced by a sensor of the apparatus of Figure **3** as a tool joint is passed therethrough.
- Figure **6**: is perspective view of an apparatus for sensing the location of a pipe joint according to a further embodiment of the present invention.
- Figure **7**: is a side view an apparatus for sensing the location of a pipe joint according to a further embodiment of the present invention.
- Figure **8**: is a cross-sectional view of the apparatus of Figure **1** with a pipe therein.
- Figure **9**: is a detailed cross sectional view of one of the magnetic stacks of the apparatus of Figure **3****.**

### DETAILED DESCRIPTION

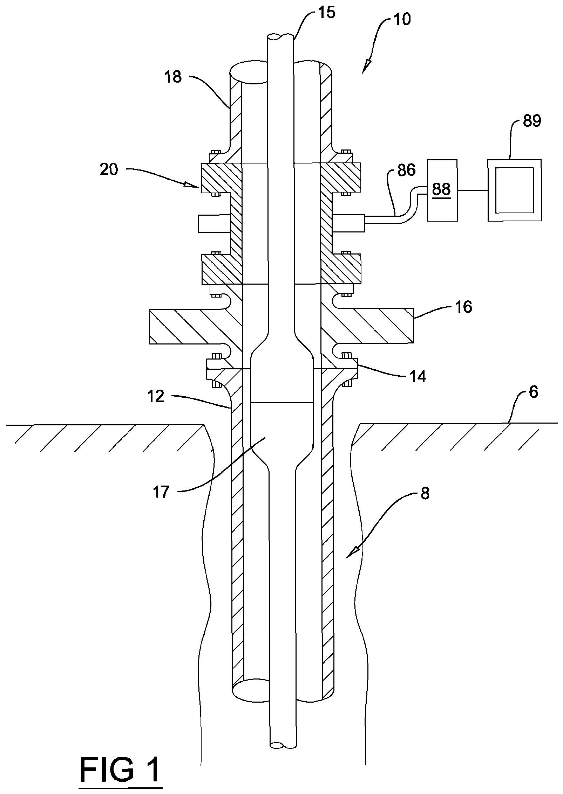

Referring to Figure **1****,** a well assembly located within a well bore **8** of a soil formation **6** is illustrated generally at **10.** The well assembly includes a well casing **12** having top flange **14** which is securable to a pipe ram **16** or any other desired well head device. It will be appreciated that the present apparatus may be located at any location within the well, such as, by way of non-limiting example, the riser, snubbing stack, blow out preventer or any other well apparatus. It will also be appreciated that although only a single pipe ram is illustrated in Figure **1** for the sake of clarity, it will be appreciated that many installations will include more than one well head component. As illustrated in Figure **1****,** the well assembly includes an apparatus for sensing a pipe joint according to a first embodiment of the invention, shown generally at **20** and one or more top pipe, well component or other equipment **18** located thereabove. A production or tool string **15** is located within the casing and includes a plurality of tool joints **17** therealong.

The apparatus **20** senses the presence of the tool joint **17** and outputs a signal to a computer **88** and/or display **89** so as to indicate to a user that the tool joint **17** located within apparatus **20** so as to permit the user to advance the production or tool string **15** within the casing **12** by a predetermined distance so as to avoid having one of the pipe rams **16** or other well head devices engage upon the tool joint.

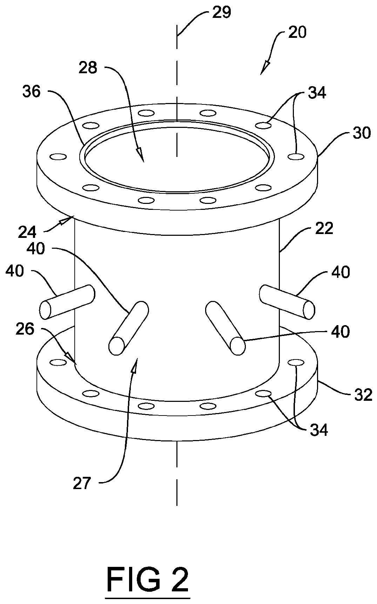

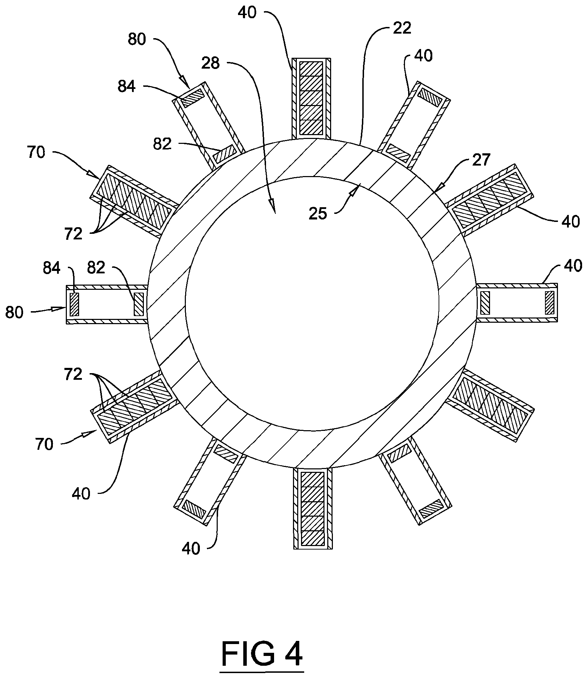

With reference to Figure **2****,** the apparatus **20** comprises a tubular member or body **22** extending between top and bottom ends, **24** and **26,** respectively and extending between inner and outer surfaces, **25** and **27,** respectively. The tubular member **22** includes a plurality of magnetic and sensor stacks, **70** and **80** extending therefrom as will be more fully described below. Optionally each of the sensor and magnetic stacks **70** and **80** may be contained within a housing, such as, by way of non-limiting example, a sleeve **40** extending from the outer surface of the tubular member **22.** As illustrated, the inner and outer surfaces **25** and **27** of the tubular member **22** are substantially cylindrical about a central axis **29** and the inner surface **25** defines a central passage **28** extending therethrough which may be sized and shaped to correspond to the interior of the casing **12.** As illustrated in Figures **2** and **4****,** the top and bottom surfaces of the top and bottom flanges **30** and **32** are substantially planar along a plane normal to the axis **29** and may optionally include a seal groove **36** extending annularly therearound for receiving a seal as are commonly known in the art.

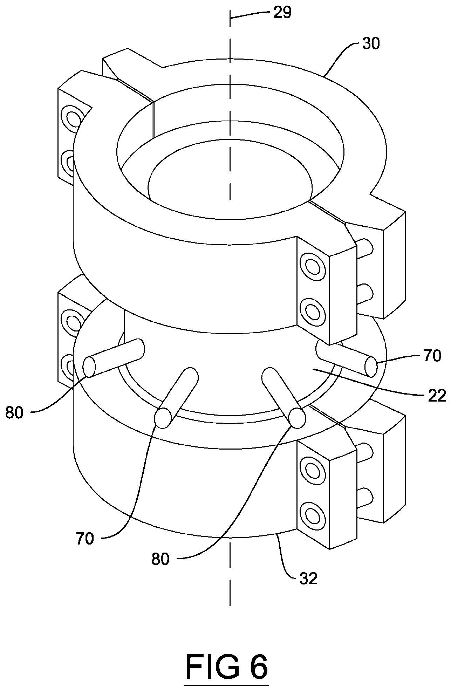

The apparatus **20** includes top and bottom flanges, **30** and **32,** respectively, adjacent to and connected to each of the top and bottom ends **24** and **26** of the tubular member so as to form a continuous body therewith. As illustrated, each of the top and bottom flanges **30** and **32** and the tubular member **22** includes the central passage **28** extending therethrough along a common central axis **29.** The top and bottom flanges **30** and **32** are sized to have a larger outer diameter than the tubular member **22** so as to overhang the tubular member and include a plurality of bores **34** therethrough for securing to adjacent structures within the well head, such as, by way of non-limiting example, pipe rams, or the like. Optionally, the apparatus may be formed as a hub clamp wherein the top and bottom flanges **30** and **32** may comprise clamping bodies adapted to clamp adjacent pipes as illustrated in Figure **6** as are commonly known. In operation, the top and bottom flanges **30** and **32** may be secured to such additional structures through the use of bolts or the like as is commonly known. Optionally, the apparatus may be formed as a hub clamp wherein the top and bottom flanges **30** and **32** may comprise clamping bodies adapted to clamp adjacent pipes as illustrated in Figure **6** as are commonly known.

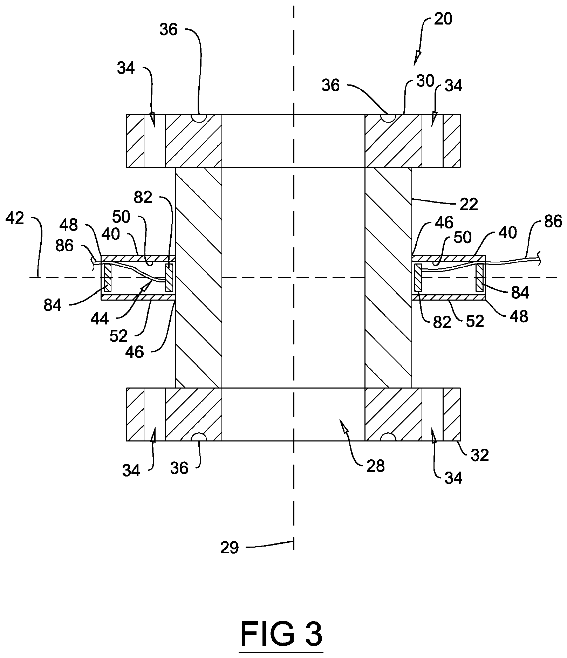

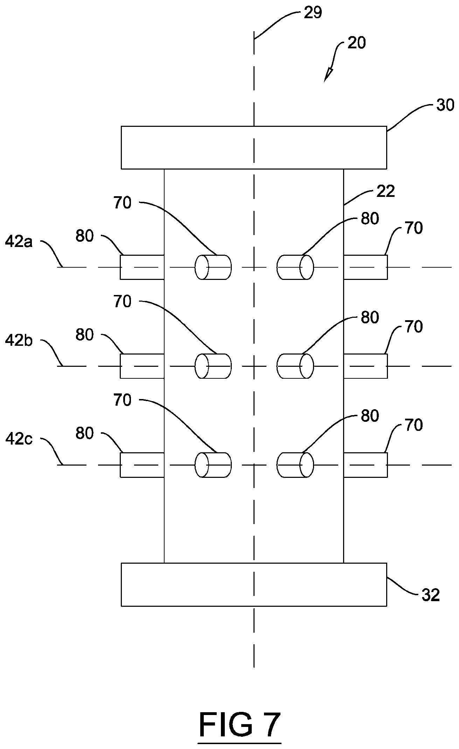

As set out above the tubular body **22** may optionally include a plurality of housings adapted to contain and protect the sensor and magnetic stacks **70** and **80** extending radially from the outer surface **27** of the tubular body. As illustrated in Figures **2-4****,** the housings may comprise sleeves extending radially from the tubular body **22.** It will be appreciated that the magnetic and sensor stacks **70** and **80** may also extend from the outside surface **27** of the tubular body **22** without such housing or sleeve therearound. As illustrated in Figure **3****,** each of the sleeves **40** may be located at a position along the tubular body **22** so as to form a common plane **42** perpendicular to the central axis **29** of the apparatus. As illustrated in Figure **7****,** the magnetic and sensor stacks **70** and **80** may also be arranged along more than one plane **42**a**, 42**b and **42**c so as to form sensor locations enabling a user to track the progress of a pipe through the apparatus **20.**

The sleeves **40** comprise tubular members extending between first and second ends, **46** and **48,** respectively, and having inner and outer surfaces, **50** and **52,** respectively. The sleeves **40** may be formed of a substantially ferromagnetic material, such as steel so as to conduct magnetic flux as will be more fully described below. The sleeves **40** are selected to have a sufficient inner surface diameter sufficient to accommodate a magnetic stack **70** or a sensor stack **80** therein as more fully described below. By way of non-limiting example it has been found that a diameter of the inner surface of between **0.5** and **6** inches (**13** and **152** mm) has been useful. The sleeve **40** may also have a length sufficient to receive the sensor and magnet stacks therein, such as by way of non-limiting example, between **0.5** and **6** inches (**13** and **152** mm). Additionally, it will be appreciated that where other housing types are utilized, such housings may be formed of any suitable size to contain and protect the magnetic and sensor stacks from impacts or the like.

Turning now to Figures **3** and **4****,** the sleeves **40** are arranged around the tubular body **22** along a common plane **42.** The common plane **42** is perpendicular to the central axis **29** and may be located at any height along the tubular body such as by way of non-limiting example, midpoint therealong as illustrated in Figure **3****.** As illustrated in Figure **4****,** the sleeves **40** may be arranged around the tubular body **22** at regular intervals. As illustrated herein, sleeves **40** are secured to the outer surface **27** of the tubular body **22** so as to form a blind bore **44** therewith. The sleeves **40** contain therein at least one magnetic stack **70** and at least one sensor stack **80** wherein the magnetic stack **70** forms a magnetic field within the interior of the central passage **28** and the sensor stack **80** measures changes in this magnetic field in response to an object passing therethrough. In particular, the magnetic stacks **70** and sensor stacks **80** may be alternated around the tubular body **22** and it will therefore be appreciated that an even number of sleeves will be required. It will also be appreciated that other arrangements of magnetic and sensor stacks may be useful as well.

The magnetic stack **70** comprises a plurality of magnets sized to be located within the sleeve **40.** The magnets **60** are selected to have strong magnetic fields. In particular, it has been found that rare earth magnets, such as, by way of non-limiting example, neodymium, samarium-cobalt or electromagnets. Optionally, the magnets **60** may also be nickel plated or otherwise coated for corrosion resistance.

The sensor stack **80** comprises a sensor **82** adapted to provide an output signal in response to the magnetic field in their proximity. By way of non-limiting example, the sensors **82** may comprise magnetic sensors, such as hall effect sensors although it will be appreciated that other sensor types may be utilized as. In particular it has been found that a hall effects sensor, such as a model SS**496**A**1** sensor manufactured by Honeywell^{®} has been particularly useful although it will be appreciated that other sensors will also be suitable. The sensors **82** are inserted into the sleeves **40** to be proximate to the first end **46** thereof and are retained within the sleeves by any suitable means, such as, by way of non-limiting example, adhesives, threading, fasteners or the like. The sensor **82** includes an output wires **86** extending therefrom as illustrated in Figure **1****.** The output wire **86** is wired or otherwise connected to a computer **88** which optionally outputs to a display **89** and is therefore operable to provide an output signal representing the width of a metallic object located within the central passage **28** such as the drill string.

The sensor stack **80** may also optionally include a magnet **84** located at the second end **48** of the sleeve **40.** The magnets **84** are selected to have strong magnetic fields. In particular, it has been found that rare earth magnets, such as, by way of non-limiting example, neodymium, samarium-cobalt or electromagnets. Optionally, the magnets **60** may also be nickel plated or otherwise coated for corrosion resistance. The magnets **84** are located at the second ends **48** of the sleeves **40** and retained in place by any suitable means, such as, by way of non-limiting example, adhesives, threading, fasteners or the like.

The apparatus **20** may have any depth between the top and bottom surfaces as is desired by a user. Similarly, the top and bottom flanges **30** and **32** may have a thickness selected to provide sufficient strength to the apparatus so as to maintain the structural integrity of the well. Additionally, the apparatus will be selected to have an inner diameter of the inner surface **25** to correspond to the inner passage of the casing **12** for which it is to be used and an outer surface **27** diameter so as to provide a sufficient strength to maintain the anticipated pressure within the well according to well known means for the pressures and temperatures expected within the well bore. The tubular body **22** may be formed of a non-magnetic material, such as, by way of non-limiting example a nickel-chromium based alloy, such as Inconel ^{®} manufactured by Special Metals Corporation. It will also be appreciated that other materials may be useful as well, such as, by way of non-limiting example duplex and super duplex stainless steels provided they do not interfere with the sensor operation as described below. The top and bottom flanges **30** and **32** are formed of a ferrous alloy such as, by way of non-limiting example, **4130** and **4140** steel although other metals such as, by way of non-limiting example, super duplex and stainless steel, may be useful here as well. Optionally, the top and bottom flanges may also be formed of a similar non-magnetic material as the tubular body **22.** The flanges **30** and **32** and the tubular body **22** may be connected to each other through any known method such as, by way of non-limiting example, welding or the like so as to form a unitary body.

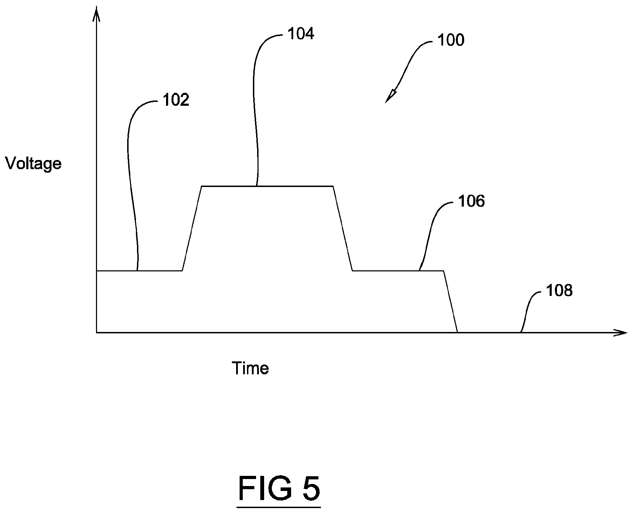

With reference to Figure **5****,** the output **100** may display the voltage signal outputted by the one or more sensors against time. During a first time period, the voltage signal will be at a first level, generally indicated at **102,** while a main portion of the pipe is drawn through the apparatus **20.** As the tool joint **17** is drawn through the apparatus **20,** the voltage output of the sensors **82** will be increased, generally indicated at **104,** due to the increased diameter of the metallic object within the central passage **28.** After the tool joint **17** passes the apparatus, the voltage will return to a lower level **106.** In such a manner, the display **100** will indicate to an operator when the tool joint **17** is located within the sleeve. Thereafter, the operator will be able to advance the production or tool string **15** by a known distance so as to ensure that the pipe rams **16** or other equipment avoids the tool joint **17.** The system may also optionally display a zero pipe condition generally illustrated at **108** in which the pipe is removed from the well bore.

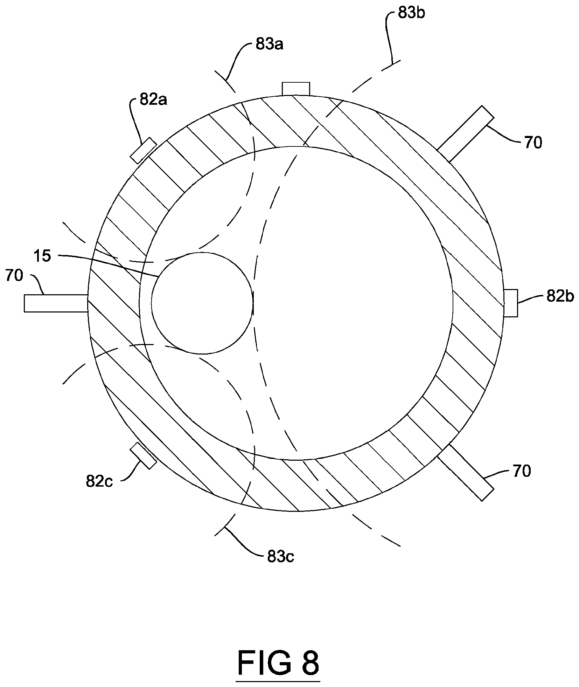

The sensors **82** may be calibrated prior to operation by locating a magnetic body of known size and position within the central passage **28** and adjusting the readout for each sensor **82**a, **82**b and **8**c according to known methods. Thereafter, in operation, each of the sensors **82** measures a distance to the pipe as illustrated generally at **83**a, **83**b and **83**c in Figure **8** wherein the measured distance from each of the sensors is then compared to each other to estimate the size and position of the tool string **15** or pipe utilizing triangulation according to known methods. As illustrated in Figure **8****,** a single set of **3** sensors may be utilized to provide such location. It will be appreciated, that additional sets of **3** or more sensors may also be provided to provide an additional measure of the position of the pipe. Such multiple positions and size of the pipe may then be compared to and averaged with each other to improve accuracy of the system.

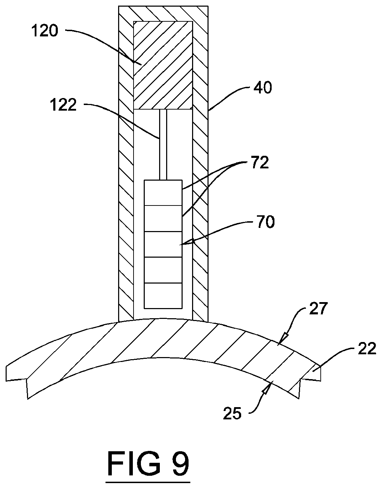

Turning now to Figure **9****,** a detailed cross sectional view of one of the magnetic stacks **70** is illustrated. As illustrated in Figure **9****,** the magnetic stack **70** may be located within a sleeve **40** which also includes an actuator **120** and an actuator shaft **122** extending from the actuator **120** to the magnetic stack **70.** In operation, the actuator **120** may extend or retract the magnetic stack **70** into and out of engagement with the outer surface **27** of the tubular body **22.** In the retracted position, the magnetic field produced by the magnetic stack **70** will be reduced thereby permitting any ferromagnetic particles attracted thereto to be released from the interior of the central passage.

While specific embodiments of the invention have been described and illustrated, such embodiments should be considered illustrative of the invention only and not as limiting the invention as construed in accordance with the accompanying claims.

## Claims

1. An apparatus (20) for measuring a pipe within a well structure, the apparatus comprising:
a tubular body (22) formed of a non-magnetic alloy metal, the tubular body (22) extending between a first end (24) and a second end (26), the tubular body (22) having an inner surface (25) defining a passage (28) therethrough and an outer surface (27);
a first flange (30) connected to the first end (24) of the tubular body (22), the first flange (30) having an inner surface defining a passage therethrough, the passage of the first flange (30) corresponding to the passage (28) of the tubular body (22);
a second flange (32) connected to the second end (26) of the tubular body (22), the second flange (32) having an inner surface defining a passage therethrough, the passage of the second flange (32) corresponding to the passage (28) of the tubular body (22);
at least one sensor stack (80) comprising a sensor (82) adapted to measure magnetic field strength; and
at least one magnetic stack (70) comprising at least one magnet (60),
wherein the at least one sensor stack (80) and the at least one magnetic stack (70) are external to the outer surface (27) of the tubular body (22), wherein the apparatus (20) is connectable inline with the well structure,
**characterized in that**
the first flange (30) and the second flange (32) are formed of a magnetic alloy metal.

2. The apparatus (20) of claim 1, wherein the tubular body (22) comprises at least one housing which extends around the at least one sensor stack (80) or the at least one magnetic stack (70).

3. The apparatus (20) of claim 2, wherein the at least one housing each comprises at least one sleeve (40).

4. The apparatus (20) of claim 3, wherein the at least one sleeve (4) is formed of a ferrous metal alloy.

5. The apparatus (20) of claim 3, wherein the at least one sensor stack (80) and the at least one magnetic stack (70) extend radially from the tubular body (22).

6. The apparatus (20) of claim 1, wherein the at least one sensor stack (80) comprises a sensor adapted to provide an output signal representing a diameter of a metallic object located within the passage (28) of the tubular body (22).

7. The apparatus (20) of claim 6, wherein the at least one sensor stack (80) comprises a Hall-effect sensor.

8. The apparatus (20) of claim 6, wherein the at least one sensor stack (80) is located proximate to the outer surface (27) of the tubular body (22).

9. The apparatus (20) of claim 6, wherein the at least one sensor stack (80) comprises a magnet (84) located at an end of a blind bore which is opposite to the at least one sensor stack (80).

10. The apparatus (20) of claim 1, wherein the at least one magnet (60) comprises a plurality of magnets.

11. The apparatus (20) of claim 1, wherein the at least one magnet (60) comprises a rare earth magnet.

12. The apparatus (20) of claim 1, wherein the at least one magnet (60) comprises an electromagnet.

13. The apparatus (20) of claim 1, wherein the at least one sensor stack (80) and the at least one magnetic stack (70) are arranged around the tubular body (22).

14. The apparatus (20) of claim 13, wherein the at least one sensor stack (80) and the at least one magnetic stack (70) are arranged at regular intervals around the tubular body (22).

15. The apparatus (20) of claim 13, wherein the at least one sensor stack (80) and the at least one magnetic stack (70) are arranged along a common plane (42) perpendicular to an axis (29) of the tubular body (22).

16. The apparatus (20) of claim 13, wherein the at least one sensor stack (80) and the at least one magnetic stack (70) are arranged along a plurality of planes.

17. A system for measuring a pipe within a well structure, the system comprising:
the apparatus (20) as defined in claim 1; and
a display (89) adapted to receive an output from the at least one sensor stack (80) and
provide a display to a user indicating the diameter of an object within the passage of the tubular body (22).

## Patentansprüche

1. Vorrichtung (20) zum Messen eines Rohres innerhalb einer Bohrlochstruktur, wobei die Vorrichtung umfasst:
einen rohrförmigen Körper (22), der aus einem nichtmagnetischen Legierungsmetall gebildet ist, wobei sich der rohrförmige Körper (22) zwischen einem ersten Ende (24) und einem zweiten Ende (26) erstreckt, wobei der rohrförmige Körper (22) eine Innenfläche (25), die eine Passage (28) dadurch definiert, und eine Außenfläche (27) aufweist;
einen ersten Flansch (30), der mit dem ersten Ende (24) des rohrförmigen Körpers (22) verbunden ist, wobei der erste Flansch (30) eine Innenfläche, die eine Passage dadurch definiert, aufweist, wobei die Passage des ersten Flansches (30) mit der Passage (28) des rohrförmigen Körpers (22) korrespondiert;
einen zweiten Flansch (32), der mit dem zweiten Ende (26) des rohrförmigen Körpers (22) verbunden ist, wobei der zweite Flansch (32) eine Innenfläche,
die eine Passage dadurch definiert, aufweist, wobei die Passage des zweiten Flansches (32) mit der Passage (28) des rohrförmigen Körpers (22) korrespondiert;
mindestens einen Sensorstapel (80) umfassend einen Sensor (82), der ausgelegt ist Magnetfeldstärke zu messen; und
mindestens einen magnetischen Stapel (70) umfassend mindestens einen Magneten (60),
wobei der mindestens eine Sensorstapel (80) und der mindestens eine magnetische Stapel (70) außerhalb der Außenfläche (27) des rohrförmigen Körpers (22) liegen, wobei die Vorrichtung (20) inline mit der Bohrlochstruktur verbindbar ist,
**dadurch gekennzeichnet, dass**
der erste Flansch (30) und der zweite Flansch (32) aus einem magnetischen Legierungsmetall gebildet sind.

2. Vorrichtung (20) nach Anspruch 1, wobei der rohrförmige Körper (22) mindestens ein Gehäuse umfasst, das sich um den mindestens einen Sensorstapel (80) oder den mindestens einen magnetischen Stapel (70) herum erstreckt.

3. Vorrichtung (20) nach Anspruch 2, wobei das mindestens eine Gehäuse jeweils mindestens eine Hülse (40) umfasst.

4. Vorrichtung (20) nach Anspruch 3, wobei die mindestens eine Hülse (4) aus einer Eisenmetalllegierung gebildet ist.

5. Vorrichtung (20) nach Anspruch 3, wobei sich der mindestens eine Sensorstapel (80) und der mindestens eine magnetische Stapel (70) radial von dem rohrförmigen Körper (22) erstrecken.

6. Vorrichtung (20) nach Anspruch 1, wobei der mindestens eine Sensorstapel (80) einen Sensor umfasst, der dazu ausgelegt ist, ein Ausgangssignal zu liefern, das einen Durchmesser eines metallischen Objekts repräsentiert, das sich innerhalb der Passage (28) des rohrförmigen Körpers (22) befindet.

7. Vorrichtung (20) nach Anspruch 6, wobei der mindestens eine Sensorstapel (80) einen Hall-Effekt-Sensor umfasst.

8. Vorrichtung (20) nach Anspruch 6, wobei der mindestens eine Sensorstapel (80) nahe der Außenfläche (27) des rohrförmigen Körpers (22) angeordnet ist.

9. Vorrichtung (20) nach Anspruch 6, wobei der mindestens eine Sensorstapel (80) einen Magneten (84) umfasst, der sich an einem Ende einer Sackbohrung befindet, die dem mindestens einen Sensorstapel (80) gegenüberliegt.

10. Vorrichtung (20) nach Anspruch 1, wobei der mindestens eine Magnet (60) eine Vielzahl von Magneten umfasst.

11. Vorrichtung (20) nach Anspruch 1, bei der der mindestens eine Magnet (60) einen Seltenerdmagneten umfasst.

12. Vorrichtung (20) nach Anspruch 1, wobei der mindestens eine Magnet (60) einen Elektromagneten umfasst.

13. Vorrichtung (20) nach Anspruch 1, wobei der mindestens eine Sensorstapel (80) und der mindestens eine magnetische Stapel (70) um den rohrförmigen Körper (22) herum angeordnet sind.

14. Vorrichtung (20) nach Anspruch 13, wobei der mindestens eine Sensorstapel (80) und der mindestens eine magnetische Stapel (70) in regelmäßigen Abständen um den rohrförmigen Körper (22) angeordnet sind.

15. Vorrichtung (20) nach Anspruch 13, wobei der mindestens eine Sensorstapel (80) und der mindestens eine magnetische Stapel (70) entlang einer gemeinsamen Ebene (42), die senkrecht zu einer Achse (29) des rohrförmigen Körpers (22) verläuft, angeordnet sind.

16. Vorrichtung (20) nach Anspruch 13, wobei der mindestens eine Sensorstapel (80) und der mindestens eine magnetische Stapel (70) entlang einer Vielzahl von Ebenen angeordnet sind.

17. System zum Messen eines Rohres innerhalb einer Bohrlochstruktur, wobei das System umfasst:
die Vorrichtung (20) wie in Anspruch 1 definiert; und
eine Anzeige (89) ausgebildet ein Ausgangssignal von dem mindestens einen Sensorstapel (80) zu empfangen und einem Benutzer eine Anzeige zu liefern,
die den Durchmesser eines Objekts innerhalb der Passage des rohrförmigen Körpers (22) angibt.

## Revendications

1. Appareil (20) pour mesurer un tuyau dans une structure de puits, l'appareil comprenant :
un corps tubulaire (22) formé avec un métal en alliage non magnétique, le corps tubulaire (22) s'étendant entre une première extrémité (24) et une seconde extrémité (26), le corps tubulaire (22) ayant une surface interne (25) définissant un passage (28) à travers cette dernière et une surface externe (27) ;
une première bride (30) raccordée à la première extrémité (24) du corps tubulaire (22), la première bride (30) ayant une surface interne définissant un passage à travers cette dernière, le passage de la première bride (30) correspondant au passage (28) du corps tubulaire (22) ;
une seconde bride (32) raccordée à la seconde extrémité (26) du corps tubulaire (22), la seconde bride (32) ayant une surface interne définissant un passage à travers cette dernière, le passage de la seconde bride (32) correspondant au passage (28) du corps tubulaire (22) ;
au moins un empilement de capteurs (80) comprenant un capteur (82) conçu pour mesurer la résistance au champ magnétique ; et
au moins un empilement magnétique (70) comprenant au moins un aimant (60),
dans lequel l'au moins un empilement de capteurs (80) et l'au moins un empilement magnétique (70) sont externes à la surface externe (27) du corps tubulaire (22), où l'appareil (20) peut être raccordé en ligne avec la structure de puits,
**caractérisé en ce que** :
la première bride (30) et la seconde bride (32) sont formées avec un métal en alliage magnétique.

2. Appareil (20) selon la revendication 1, dans lequel le corps tubulaire (22) comprend au moins un boîtier qui s'étend autour de l'au moins un empilement de capteurs (80) ou de l'au moins un empilement magnétique (70).

3. Appareil (20) selon la revendication 2, dans lequel l'au moins un boîtier comprend au moins un manchon (40) .

4. Appareil (20) selon la revendication 3, dans lequel l'au moins un manchon (4) est formé avec un alliage de métal ferreux.

5. Appareil (20) selon la revendication 3, dans lequel l'au moins un empilement de capteurs (80) et l'au moins un empilement magnétique (70) s'étendent radialement à partir du corps tubulaire (22).

6. Appareil (20) selon la revendication 1, dans lequel l'au moins un empilement de capteurs (80) comprend un capteur conçu pour fournir un signal de sortie représentant un diamètre d'un objet métallique situé à l'intérieur du passage (28) du corps tubulaire (22).

7. Appareil (20) selon la revendication 6, dans lequel l'au moins un empilement de capteurs (80) comprend un capteur à effet Hall.

8. Appareil (20) selon la revendication 6, dans lequel l'au moins un empilement de capteurs (80) est situé à proximité de la surface externe (27) du corps tubulaire (22) .

9. Appareil (20) selon la revendication 6, dans lequel l'au moins un empilement de capteurs (80) comprend un aimant (84) situé au niveau d'une extrémité d'un alésage borgne qui est opposé à l'au moins un empilement de capteurs (80).

10. Appareil (20) selon la revendication 1, dans lequel l'au moins un aimant (60) comprend une pluralité d'aimants.

11. Appareil (20) selon la revendication 1, dans lequel l'au moins un aimant (60) comprend un aimant de terre rare.

12. Appareil (20) selon la revendication 1, dans lequel l'au moins un aimant (60) comprend un électroaimant.

13. Appareil (20) selon la revendication 1, dans lequel l'au moins un empilement de capteurs (80) et l'au moins un empilement magnétique (70) sont agencés autour du corps tubulaire (22).

14. Appareil (20) selon la revendication 13, dans lequel l'au moins un empilement de capteurs (80) et l'au moins empilement magnétique (70) sont agencés à intervalles réguliers autour du corps tubulaire (22).

15. Appareil (20) selon la revendication 13, dans lequel l'au moins un empilement de capteurs (80) et l'au moins un empilement magnétique (70) sont agencés le long d'un plan commun (42) perpendiculaire à un axe (29) du corps tubulaire (22).

16. Appareil (20) selon la revendication 13, dans lequel l'au moins un empilement de capteurs (80) et l'au moins un empilement magnétique (70) sont agencés le long d'une pluralité de plans.

17. Système pour mesurer un tuyau dans une structure de puits, le système comprenant :
l'appareil (20) selon la revendication 1 ; et
un affichage (89) conçu pour recevoir une sortie de l'au moins un empilement de capteurs (80) et fournir un affichage à un utilisateur indiquant le diamètre d'un objet à l'intérieur du passage du corps tubulaire (22).
